# EUROPEAN PATENT APPLICATION

(11) **EP 3 806 151 A1**
(43) Date of publication of application: **14.04.2021**
(21) Application number: 19201933.9
(22) Date of filing: 08.10.2019
(51) Int. Cl.: H01L 27/12, H01L 29/786

(54) **THIN-FILM TRANSISTOR ARCHITECTURE FOR HIGH RESOLUTION DISPLAYS**

(71) Applicant: Imec VZW, 3001 Leuven (BE); Katholieke Universiteit Leuven KU Leuven Research & Development, 3000 Leuven (BE)
(72) Inventor: VERSCHUEREN, Lynn, 3001 Leuven (BE); GLUSHKOVA, Anastasia, 3001 Leuven (BE); NAG, Manoj, 3001 Leuven (BE)
(74) Representative: AWA Sweden AB

(57) **Abstract**

A semiconductor thin-film transistor, TFT, stack (200) is provided. The stack (200) includes a first TFT structure and a second TFT structure. A same metal layer (232, 233) is configured as both i) a gate metal (232) of one of the first TFT structure and the second TFT structure, and ii) a source-drain metal (232, 233) of the other one of the first TFT structure and the second TFT structure. A display of an active matrix LED type is also provided. The display includes a plurality of pixels and, for each pixel, a pixel driving circuit formed at least partly by the disclosed semiconductor TFT stack.

## Description

### Technical field

The present disclosure relates to the field of displays. In particular, the present disclosure relates to a semiconductor thin-film transistor architecture (stack) useable in displays.

### Background

Due to their higher contrast, flexibility and lower power consumption, active-matrix LED type displays (such as e.g. AMOLED, AMLED, or AMµLED, displays) have gained industrial attention. However, as such displays normally require at least two transistors (such as e.g. thin-film transistors, TFTs; or for example silicon field-effect transistors, FETs) to drive each pixel (or subpixel), the achievable resolution in such displays is often limited due to the area required to fit the transistors themselves and the routings and VIAs required to connect the transistors together.

Such a limitation in resolution may impose a challenge when using the displays for products and applications where higher resolutions are required or at least desired, including for example smartphones and various augmented/virtual reality applications. There is therefore a need for an improved transistor architecture which overcomes the above challenge.

### Summary

To at least partly satisfy the above need, the present disclosure provides a semiconductor thin-film transistor (TFT) architecture (or stack) and a display as defined in the independent claims. Further embodiments of the stack and the display are defined in the dependent claims.

According to a first aspect of the present disclosure, a semiconductor TFT stack is provided. The stack includes a first thin-film transistor structure and a second TFT structure. Within the stack (or architecture), a same metal (or metallic) layer is configured as both i) a gate metal of one of the first TFT structure and the second TFT structure, and ii) a source-drain metal of the other one of the first TFT structure and the second TFT structure.

Using a same metal layer as both the gate metal of one TFT structure and the source-drain metal of the other TFT structure may eliminate the need for at least one VIA inside the pixel and stack, and hence reduce the required area. The resolution of a display using the stack may thus be increased, while still meeting e.g. specifications imposed by currently available tools for display manufacturing. Compared to e.g. crystalline Si processes, the stack according to the first aspect may also provide a lower manufacturing cost and allow for larger area displays.

In some embodiments, the first TFT stack may be a vertical TFT stack, and the second TFT structure may be a non-vertical TFT structure. Herein, a "non-vertical" TFT structure may for example be a coplanar TFT structure, a staggered TFT structure, or, as will also be described later herein, a staggered source-drain (SD) TFT structure. Combining a vertical TFT structure with a non-vertical TFT structure may further reduce the required area, especially as the vertical TFT structure may have a further reduced footprint.

In some embodiments, both of the first TFT structure and the second TFT structure may be non-vertical TFT structures. With two non-vertical TFT stacks, there may be no need for a VIA to go from the source/drain of the select TFT to the gate of the drive TFT. This elimination of the VIA may significantly reduce the require area of the stack.

In some embodiments, the (same) metal layer may be configured as a gate metal of the vertical TFT structure and as a source-drain metal of the coplanar or staggered TFT structure.

In some embodiments, the vertical TFT structure may be configured as a drive transistor and the coplanar or staggered TFT structure may be configured as a select transistor. As will be described later herein, this may make the circuit suitable e.g. for digital driving.

In some embodiments, the (same) metal layer may be configured as a source-drain metal of the vertical TFT structure and as a gate metal of the coplanar or staggered TFT structure.

In some embodiments, the vertical TFT structure may be configured as a select transistor and the coplanar or staggered TFT structure may be configured as a drive transistor. As will be described later herein, this may make the circuit suitable e.g. for analog driving.

In some embodiments, the first TFT structure may be arranged on top of the second TFT structure.

In some embodiments, the second TFT structure may be arranged on top of the first TFT structure.

Arranging one transistor structure on top of the other may further reduce the combined footprint of the transistor structures and the required area, and thus further increase the possible resolution.

In some embodiments, an active channel layer (or transistor channel layer) of one or both of the first TFT structure and the second TFT structure may include a metal oxide.

In some embodiments, the metal oxide may be indium gallium zinc oxide (IGZO).

According to a second aspect of the present disclosure, a display of an active-matrix LED type is provided. The display includes a plurality of pixels, and, for each pixel, a pixel driving circuit formed at least partly by a stack as described herein according to the first aspect.

In some embodiments, the display may be of a thin-film emitter type, e.g. an active-matrix thin-film emitter LED type (e.g. an AMOLED display). In other embodiments, other displays which are not necessarily thin-film emitters may also be used, such as e.g. AMLED or AMµLED displays.

The present disclosure relates to all possible combinations of features mentioned herein, including the ones listed above as well as other features which will be described in what follows with reference to different embodiments. Any embodiment described herein may be combinable with other embodiments also described herein, and the present disclosure relates also to all such combinations. For example, all limitations specified herein with reference to the stack according to the first aspect may apply also to (and/or be combinable with) the display according to the second aspect, and vice versa. Further objects and advantages of the various embodiments of the present disclosure will be described below by means of exemplifying embodiments.

### Brief description of the drawings

Exemplifying embodiments will be described below with reference to the accompanying drawings, in which:
Figure 1 illustrates schematically a generic pixel driving circuit;
Figure 2 illustrates schematically an embodiment of a semiconductor TFT stack according to the present disclosure;
Figure 3 illustrates schematically another embodiment of a semiconductor TFT stack according to the present disclosure;
Figure 4 illustrates schematically another embodiment of a semiconductor TFT stack according to the present disclosure;
Figure 5 illustrates schematically another embodiment of a semiconductor TFT stack according to the present disclosure, and
Figure 6 illustrates schematically another embodiment of a semiconductor TFT stack according to the present disclosure.

In the drawings, like reference numerals will be used for like elements unless stated otherwise. Unless explicitly stated to the contrary, the drawings show only such elements that are necessary to illustrate the example embodiments, while other elements, in the interest of clarity, may be omitted or merely suggested. As illustrated in the figures, the sizes of elements and regions may be exaggerated for illustrative purposes and, thus, are provided to illustrate the general structures of the embodiments.

### Detailed description

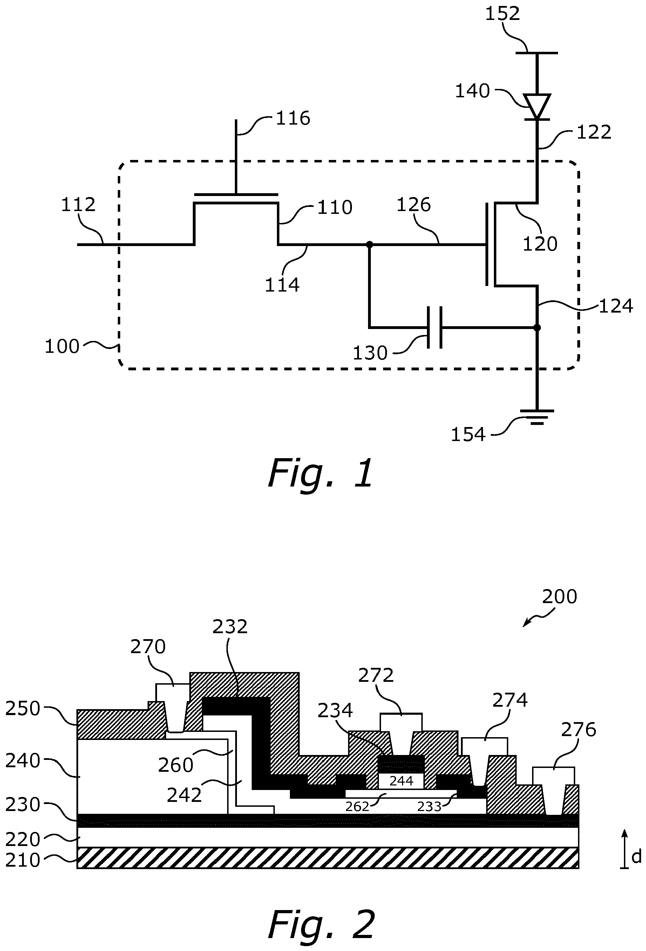

With reference to Figure 1, an example of a generic pixel driving circuit will now be described in more detail.

Figure 1 illustrates schematically a circuit diagram for a pixel driving circuit 100. The circuit 100 is of a two transistor, one capacitor (2T1C) type, and includes a first transistor 110 and a second transistor 120. The first transistor 110 is a select transistor of the circuit 100. The first transistor 110 has one terminal 112 of its source-drain terminals configured as a data (or signal) terminal. The first transistor 110 has the other terminal 114 of its source-drain terminals connected to a gate terminal 126 of the second transistor 120. The first transistor 110 has its gate terminal 116 configured as a select (or scan) terminal. The second transistor 120 has one terminal 122 of its source-drain terminals connected to a light source (e.g. a LED, OLED, or similar) 140. The light source 140 is in turn connected to a supply potential (e.g. Vdd) 152. The second transistor 120 has the other terminal 124 of its source-drain terminals connected to another potential 154, such as e.g. a ground potential (Gnd) or other potential (e.g. Vss) different from the supply potential 152. It is envisaged that the light source 140 may form part of the circuit 100, or that the light source 140 may not form part of the circuit 100. In other pixel driving circuits, it may be envisaged also that the light source 140 is instead connected between the other terminal 124 of the second transistor 120 and the another potential 154.

The circuit 100 further has a storage capacitance (e.g. a capacitor) 130 connected between the terminal 114 of the first transistor 110 (and the gate terminal 126 of the second transistor 120) and the potential terminal 124 of the second transistor 120.

When used in a display, the circuit 100 may be arranged (in an array, together with multiple other, similar or equal, circuits) such that the data (or signal) terminal 112 is connected to a data (or signal) line (not shown), such that the select (or scan) terminal 116 is connected to a select (or scan) line (not shown), and such that the potentials 152 and 154 are connected to respective supply and ground lines (not shown). By applying voltages on the various lines in a specific way, the circuit 100 may be used to control whether a current will flow through the light source 140 or not, and thus whether the light source 140 (i.e. the pixel itself, or at least part of the pixel) should illuminate or not.

Specifically, a voltage may be provided on a select (or scan) line connecting the gate terminals 116 of a row of circuits 100 together. A voltage may then be provided on a data (or signal) line connecting the terminals 112 of a column of the circuit 100 together. By the combination of both the select and data lines, a specific circuit 100 may thus be targeted, and a specific light source 140 may be controlled. If a voltage is provided to the gate terminal 116, the first transistor 110 may be turned on such that a data signal voltage provided on the terminal 112 may be transferred to the gate terminal 126 of the driving, second transistor 120. If the data signal voltage is provided while the first transistor 110 is turned on, the second transistor 120 may also be turned on, enabling a current to flow through the light source 140. Meanwhile, the data signal voltage is applied across the capacitance 130 such that the capacitance 130 is charged. When the first transistor (i.e. the select transistor) 110 is then turned off by removing (or at least changing) the voltage provided at the select line, the charge stored in the capacitance 130 may uphold a sufficient voltage at the gate terminal 126 of the second (driving) transistor 120 such that the second transistor 120 remains turned on.

In other examples, it is envisaged also that the select lines and data lines can be allocated differently, such that e.g. a select line connects terminals of a column (instead of a row) of circuits 100 together, while a data line connects terminals of a row (instead of a column) of circuits 100 together.

Exemplifying embodiments of a semiconductor TFT stack (which may form part of such a pixel driving circuit) and a display according to the present disclosure will now be described more fully hereinafter with reference to the accompanying drawings. The drawings show currently preferred embodiments, but the invention may, however, be embodied in many different forms and should not be construed as limited to the embodiments set forth herein; rather, these embodiments are provided for thoroughness and completeness, and fully convey the scope of the present disclosure to the skilled person.

With reference to Figures 2 to 6, various embodiments of a semiconductor TFT stack will now be described in more detail.

Figure 2 illustrates schematically an embodiment of a semiconductor TFT stack 200. The stack 200 includes a substrate 210. On top of the surface is provided a buffer layer 220. Herein, a buffer layer (such as the layer 220) may for example contain or consist of SiO₂, Al₂O₃, HfO₂, or e.g. SiNx. A thickness (as measured in the direction indicated by the arrow *d* in Figure 2) of the buffer layer 220 may for example be approximately 200 nm.

A metal layer 230 is provided on the buffer layer 220. The metal layer 230 may function as part of a ground plane.

Herein, when referring to an object (such as a certain layer) being arranged/provided/located "on top" of another object, it is envisaged that such an object is located such that it at least partly contacts the other object, and such that it lies further from the substrate 210 than the other object when measured in the direction indicated by the arrow *d* in Figure 2. If something is arranged/provided/located "above" another object, it is envisaged that such an object is also located further from the substrate 210 than the other object, but not necessarily contacting the other object.

A spacer 240 is provided on top of the metal layer 230. The spacer may for example contain or consist of an oxide, such as e.g. SiO₂. It is envisaged also that the spacer may be e.g. an organic layer. A thickness of the spacer 240 may for example be approximately 500 nm.

A transistor channel layer (or active channel layer) 260 is provided on top of the metal layer 230 and the spacer 240. The transistor channel layer 260 also runs laterally on the spacer 240. The transistor channel layer 260 may for example contain or consist of a metal oxide. For example, the transistor channel layer 260 may contain or consist of IGZO (indium gallium zinc oxide) or other suitable materials. A thickness of the transistor channel layer 260 may for example be approximately from 10 nm to 50 nm.

A dielectric layer 242 is provided on top of the metal layer 230 and the transistor channel layer 260, and also runs laterally on the transistor channel layer 260. The dielectric layer 242 may for example contain or consist of an oxide, such as e.g. SiO₂. A thickness of the dielectric layer 242 may for example be approximately from 20 to 200 nm.

A metal layer including two metal layer parts 232 and 233 is provided on top of the dielectric layer 242, wherein the metal layer part 232 also runs laterally on the dielectric layer 242.

Together, at least the transistor channel layer 260, the dielectric layer 242 and the metal layer part 232 define a vertical thin-film transistor (TFT) structure, wherein the metal layer part 232 acts as a gate metal for the (semiconductor) transistor channel layer 260.

The stack 200 further includes a transistor channel layer 262 provided on top of the dielectric layer 242. Contrary to the transistor channel layer 260, the transistor channel layer 262 is planar with respect to e.g. the substrate 210. The transistor channel layer 262 may for example contain or consist of IGZO. A thickness of the transistor channel layer 262 may for example be approximately between 10 to 50 nm.

A dielectric layer 244 is arranged on top of the transistor channel layer 262. The dielectric layer 244 may for example contain or consist of an oxide, such as e.g. SiO₂. A thickness of the dielectric layer 244 may for example be approximately from 20 to 200 nm.

A metal layer 234 is provided on top of the dielectric layer 244. The metal layer 234 may for example contain or consist of Mo, or other suitable materials.

The formed structure may be exposed to semiconductor 262 doping, such that the semiconductor regions not covered by layer 232 and 233 and by layer 234 may acquire a reduced resistance to facilitate charge injection to the transistor channel.

Together, at least the transistor channel layer 262, metal layer parts 232 and 233, the dielectric layer 244 and the metal layer 234 with doped regions of semiconductor 262 define a coplanar (top-gate), self-aligned TFT structure, wherein the metal layer 234 acts as a gate metal for the (semiconductor) transistor channel 262. Additionally, the metal layer part 233 is arranged such that it contacts the transistor channel layer 262, and the metal layer including the metal layer parts 232 and 233 acts as a source-drain metal for the coplanar TFT structure. Phrased differently, the metal layer including the metal layer parts 232 and 233 is configured as both a gate metal for the vertical TFT structure and as a source-drain metal for the coplanar TFT structure.

The stack 200 is further covered by a layer 250, which may contain or consist of for example dielectric (such as e.g. SiN or SiO₂). A thickness of the layer 250 may for example be approximately from 200 to 400 nm. The layer 250 may for example dope parts of the transistor channel layers 260 and 262 not covered by other objects, thereby making these parts conductive.

The stack 200 further includes contacts 270, 272, 274 and 276 provided through the layer 250. The contact 270 contacts the transistor channel layer 260 of the vertical TFT structure and may act as a contact to which a light source (such as a LED, an OLED, or similar) may be connected. The contact 270 may for example correspond to the terminal 122 of the circuit 100 illustrated in Figure 1. The contact 272 contacts the (gate) metal layer 234 of the coplanar transistor structure, and may for example correspond to the terminal 116 of the circuit 100 illustrated in Figure 1. The contact 274 contacts the metal layer part 233 of the source-drain metal layer of the coplanar TFT structure, and may for example correspond to the terminal 112 of the circuit 100 illustrated in Figure 1. Finally, the contact 276 contacts the (ground) metal layer 230 of the vertical TFT structure, and may for example correspond to the terminal 124 of the circuit 100 illustrated in Figure 1.

In summary, the arrangement of the various contacts and TFT structures of the stack 200 enables the stack 200 to form part of a drive circuit for a pixel, wherein the vertical TFT structure is used as a drive transistor and the coplanar TFT structure is used as a select transistor. The stack 200 may for example be advantageous for digital driving. For example, the vertical TFT structure may have a shorter channel length, which may give rise to problems related to output resistance for analog driving, but which may be better for higher current requirements related to digital driving.

Above, and generally herein, it should be noted that any given dimensions (such as e.g. various thicknesses of the various layers) are provided only as examples, and in particular only as a guide for the skilled person. It is envisaged that the skilled person may vary one or more of the provided dimensions while still remaining within the scope of the present disclosure.

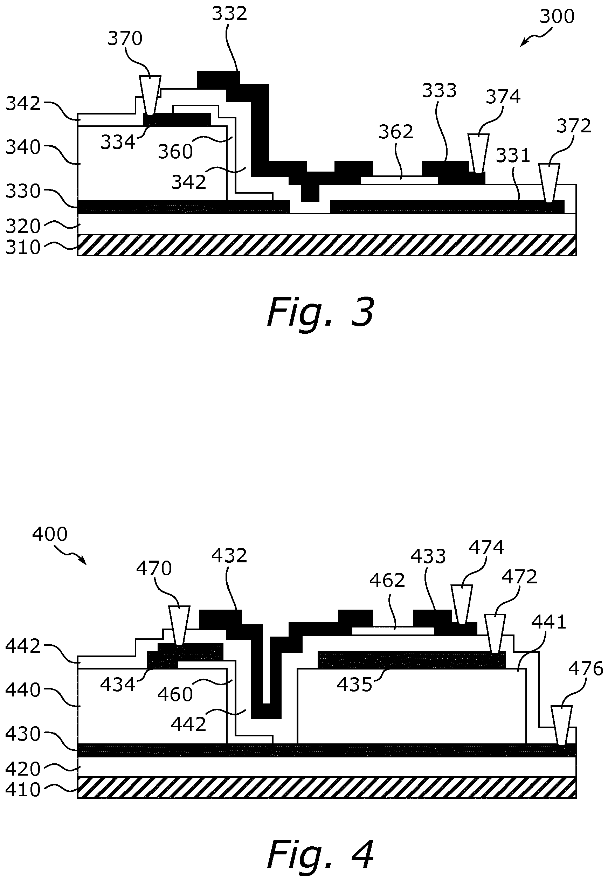

Figure 3 illustrates schematically another embodiment of a semiconductor TFT stack 300. The stack 300 includes e.g. a substrate 310, a buffer layer 320 on top of the substrate 310, and a metal layer including two metal layer parts 330 and 331 provided on top of the buffer layer 320.

A spacer 340 is provided on top of the metal layer part 330, and a metal layer 334 is provided on top of the spacer 340. A transistor channel layer 360 is provided on top of both the metal layer part 330 and the metal layer 334, and also on (both on top and laterally of) the spacer 340.

The stack 300 further includes a dielectric (or insulator/oxide) layer 342 arranged on top of, and laterally of, e.g. the metal layer 334, the transistor channel layer 360, part of the metal layer parts 330 and 331, and part of the buffer layer 320, as illustrated in Figure 3. A transistor channel layer 362 is arranged on top of the dielectric layer 342. A metal layer including metal layer parts 332 and 333 is provided on top of the dielectric layer 342 and such that the metal layer parts 332 and 333 both contact the transistor channel layer 362.

Here, in the stack 300, at least the transistor channel layer 360, part of the dielectric layer 342 and the metal layer part 332 define a vertical TFT structure, wherein the metal layer part 332 acts as a gate metal for the transistor channel layer 360. Similarly, at least the transistor channel layer 362, part of the dielectric layer 342 and the metal layer part 331 define a staggered (bottom-gate), back channel etch, TFT structure, wherein the metal layer part 331 acts as a gate metal for the transistor channel layer 362. Additionally, the metal layer including the metal layer parts 332 and 333, both contacting the transistor channel layer 362, also acts as a source-drain metal for the staggered TFT structure. Phrased differently, the metal layer including the metal layer parts 232 and 233 is configured as both a gate metal for the vertical TFT structure and as a source-drain metal for the staggered TFT structure.

The stack 300 further includes contacts 370, 372 and 374. The contact 370 extends through the dielectric layer 342 and contacts the transistor channel layer 360 via the metal layer 334. The contact 370 may for example correspond to the terminal 122 of the circuit illustrated in Figure 1, and act as a contact to which a light source may be connected. The contact 372 contacts the metal layer part 331 (i.e. the gate metal of the staggered TFT structure), and may for example correspond to the terminal 116 of the circuit 100 illustrated in Figure 1. The contact 374 contacts the metal layer part 332 of the source-drain metal of the staggered TFT structure, and may for example correspond to the terminal 112 of the circuit 100 illustrated in Figure 1. The metal layer part 330 may be contacted with a ground contact (not shown), which may for example use a same VIA as for the contact 372.

In summary, the arrangement of the various contacts and TFT structures of the stack 300 enables also the stack 300 to form part of a drive circuit for a pixel, wherein the vertical TFT structure is used as a drive transistor and the staggered TFT structure is used as a select transistor. For the same reasons as those already given for the stack 200 described with reference to Figure 2, the stack 300 may be advantageous for digital driving. Although no specific materials and/or dimensions have been given for the stack 300, it is envisaged that the materials and/or dimensions already provided with reference to the stack 200 illustrated in Figure 2 may be used and/or be adapted by the skilled person also for the stack 300.

Figure 4 illustrates schematically a further embodiment of a semiconductor TFT stack 400 similar to the stack 300 already described with reference to Figure 3. The stack 400 includes e.g. a substrate 410, a buffer layer 420 arranged on top of the substrate 410, and a metal layer 430 arranged on top of the buffer layer 420.

Two parts 440 and 441 of spacer layer are provided on top of the metal layer 430. A transistor channel layer 460 is provided on top of and laterally on the spacer 440, while a metal layer including two metal layer parts 434 and 435 is provided such that the metal layer part 434 is provided on the spacer 440 and partly on top of the transistor channel layer 460, and such that the metal layer part 435 is provided on top of the spacer 441.

The stack 400 further includes a dielectric (or insulator) layer 442 which is provided on top of, and laterally on, e.g. part of the spacers 440 and 441, the metal layer parts 434 and 435, part of the transistor channel layer 460, and part of the metal layer 430. A transistor channel layer 462 is provided on top of the dielectric layer 442. Also, the stack 400 includes a metal layer including metal layer parts 432 and 433, and arranged on top of the dielectric layer 442 and such that both metal layer parts 432 and 433 contact the transistor channel layer 462.

Together, and similarly to the stack 300 described with reference to Figure 3, at least the transistor channel layer 460, part of the dielectric layer 442 and the metal layer part 432 define a vertical TFT structure, wherein the metal layer part 432 acts as a gate metal for the transistor layer channel 460. Similarly, at least the transistor channel layer 462, part of the dielectric layer 442 and the metal layer part 435 define a staggered (bottom-gate), back-channel etch, TFT structure, wherein the metal layer part 435 acts as a gate metal for the transistor channel layer 462. Additionally, the metal layer including the metal layer parts 432 and 433, both contacting the transistor channel layer 462, also acts as a source-drain metal for the staggered TFT structure. Phrased differently, the metal layer including the metal layer parts 432 and 433 is configured as both a gate metal for the vertical TFT structure and as a source-drain metal for the staggered TFT structure.

The stack 400 also includes contacts 470, 472, 474 and 476 which all, except for the contact 474, passes through the dielectric layer 442. The contact 470 contacts the transistor channel layer 460 via the metal layer part 434, and may for example correspond to the terminal 122 of the circuit 100 illustrated in Figure 1. The contact 470 may for example serve as a contact to which a terminal of light source (e.g. a cathode of a diode) may be connected. The contact 472 contacts the metal layer part 435, and may correspond to the terminal 116 of the circuit 100 illustrated in Figure 1. The contact 474 contacts the metal layer part 433 of the source-drain metal layer of the staggered TFT structure, and may for example correspond to the terminal 112 of the circuit 100 illustrated in Figure 1. Finally, the contact 476 contacts the (ground) metal layer 430, and may for example correspond to the terminal 124 of the circuit 100 illustrated in Figure 1.

In summary, the arrangement of the various contacts and TFT structures of the stack 400 much resembles that of the stack 300 described with reference to Figure 3, and enables also the stack 400 to form part of a drive circuit for a pixel, wherein the vertical TFT structure is used as a drive transistor and the staggered TFT structure is used as a select transistor. Likewise, the stack 400 may be advantageous for digital driving. Although no specific materials and/or dimensions have been given for the stack 400, it is envisaged that the materials and/or dimensions already provided with reference to the stack 200 illustrated in Figure 2 may be used and/or be adapted by the skilled person also for the stack 400.

More in general, the various semiconductor TFT stacks 200, 300 and 400, and other embodiments thereof according to the present disclosure, may require less area compared with traditional stacks used for pixel driving circuits. This may help to increase the achievable resolution of e.g. a display in which a pixel driving circuit including (e.g. formed at least partly by) a stack according to the present disclosure may be used to drive each pixel. A 2T1C driving circuit requires two transistors: one drive transistor and one select transistor. With a stack according to the present disclosure, the use of a same metal layer both as a gate metal for one of the transistor structures, and as a source-drain metal for the other transistor structure, allows to eliminate at least one VIA for each pixel and hence reduce the required area. Furthermore, as one of the transistor structures may be a vertical transistor, the footprint of this transistor may be even smaller, and a stack according to the present disclosure may therefore result in an even further reduced area requirement and an even further increased resolution.

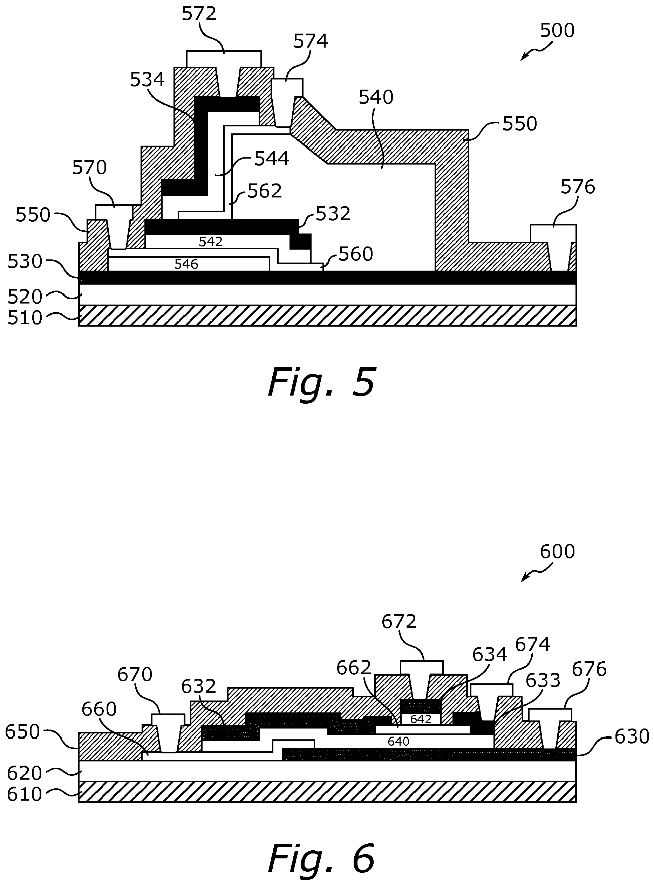

Figure 5 illustrates schematically a further embodiment of a semiconductor TFT stack 500. The stack 500 includes e.g. a substrate 510, a buffer layer 520 provided on top of the substrate 510, and a metal layer 530 provided on top of the buffer layer 520.

A dielectric layer 546 is provided on top of the metal layer 530, and a transistor channel layer 560 is provided partly on top of the dielectric layer 546 and partly on top of the metal layer 530. A dielectric layer 542 is provided on top of the transistor channel layer 560, and a metal layer 532 is provided on top of the dielectric layer 542. Together, at least the transistor channel layer 560, the dielectric layer 542 and the metal layer 532 define a (top-gate) TFT structure, wherein the metal layer 532 acts as a gate metal for the transistor channel layer 560. Herein, such a top-gate TFT structure may be referred to as a "staggered source-drain (SD)" TFT structure, as one of the source-drain (SD) terminals and gate are on opposite sides of semiconductor, and as here also source (S) and drain (D) are on opposite side of semiconductor.

In the stack 500, a spacer 540 is further provided partly on top of the metal layer 530 and partly on top of the metal layer 532. A transistor channel layer 562 is provided partly on top of the spacer 540 and partly on top of the metal layer 532. The transistor channel layer 562 also runs laterally on the spacer 540. A dielectric layer 544 is provided mainly on top of and laterally on the transistor channel layer 562, and a metal layer 534 is provided on top of and laterally on the dielectric layer 544. Together, at least the transistor channel layer 562, the dielectric layer 544 and the metal layer 534 define a vertical TFT structure, wherein the metal layer 534 acts as a gate metal for the transistor channel layer 562. Additionally, the metal layer 532 also acts as a source-drain metal for the vertical TFT structure. Phrased differently, the metal layer 532 is configured as both a gate metal of the staggered SD TFT structure and as a source-drain metal of the vertical TFT structure.

As used everywhere herein, a "source-drain metal" is considered as being any metal layer or metal layer parts which acts or act as one or both of a source metal and a drain metal for a transistor channel layer.

The formed structure may be exposed to semiconductor layers 560 and 562 doping, such that the semiconductor regions not covered by layers 532 and 534 may acquire reduced resistance to facilitate charge injection to the transistor channel.

As in the stack 200 described with reference to Figure 2, the stack 500 is further covered by a layer 550, which may e.g. contain or consist of SiN. As already described herein, such a layer may dope any part of a transistor channel layer not covered by another object, and thereby make such part or parts conductive.

The stack 500 also includes contacts 570, 572, 574 and 576 which all extend through the layer 550. The contact 570 contacts the transistor channel layer 560, and may for example correspond to the terminal 122 of the circuit 100 illustrated in Figure 1. The contact 572 contacts the metal layer 534, and may for example correspond to the terminal 116 of the circuit 100 illustrated in Figure 1. The contact 574 contacts the transistor channel layer 562, and may for example correspond to the terminal 112 of the circuit 100 illustrated in Figure 1. Finally, the contact 576 contacts the (ground) metal layer 530, and may for example correspond to the terminal 124 of the circuit 100 illustrated in Figure 1.

In summary, the arrangement of the various contacts and TFT structures of the stack 500 enables also the stack 500 to form at least a part of a drive circuit for a pixel. However, contrary to the other stacks described above, the stack 500 is configured such that the vertical TFT structure is used as a select transistor and the staggered SD TFT structure is used as a drive transistor. This may offer an advantage if the stack 500 forms part of a drive circuit for analog driving. For example, the staggered SD TFT structure may have a longer channel length and allow to provide sufficient output resistance required for analog driving. Also, the vertical TFT structure may be used only as a switch (without having to sustain any substantial current therethrough), and eventual non-uniformities in the characteristics of the vertical TFT structure may impose less restrictions.

In addition, the stack 500 is configured such that one of the transistor structures (the vertical TFT structure) is arranged on top of (or at least above) the other transistor structure. This may help to further reduce the combined footprint of the transistor structures, and result in a reduced area requirement and thereby a further increase in resolution when multiple pixel driving circuits, formed at least partly by stacks 500, are used to drive pixels in a display. It is, within the scope of the present disclosure, envisaged also that e.g. the stacks 200, 300, and 400, as described above with reference to Figures 2, 3, and 4, respectively, may be altered such that one of the transistor structures therein is arranged on top of (or above) the other transistor structure, and thus receive the same additional benefits with regard to footprint and area requirement as described for the stack 500.

Although no specific materials and/or dimensions have been given for the stack 500, it is envisaged that the materials and/or dimensions already provided with reference to the stack 200 illustrated in Figure 2 may be used and/or be adapted by the skilled person also for the stack 500.

It should be further noted that it is envisaged also that each of the layer stacks shown as stacks 200, 300, 400, and 500 herein may be completed with one or more additional interlayers, and also with corresponding additional anode/cathode layers. In the Figures 2, 3, 4, and 5, such additional layers are not shown, but it is envisaged that the skilled person would understand how to implement such additional layers to complete the respective circuits.

Figure 6 illustrates schematically a further embodiment of a semiconductor TFT stack 600. The stack 600 includes a substrate 610. On top of the surface of the substrate 610 is provided a buffer layer 620.

A metal layer 630 is provided on the buffer layer 620. The metal layer 630 may function as part of a ground plane.

A transistor channel layer (or active channel layer) 660 is provided on top of the metal layer 630 and the buffer layer 620. The transistor channel layer 660 may for example contain or consist of a metal oxide. For example, the transistor channel layer 660 may contain or consist of IGZO (indium gallium zinc oxide) or other suitable materials. A thickness of the transistor channel layer 660 may for example be approximately from 10 nm to 50 nm.

A dielectric layer 640 is provided on top of the metal layer 630 and the transistor channel layer 660. The dielectric layer 640 may for example contain or consist of an oxide, such as e.g. SiO₂. A thickness of the dielectric layer 640 may for example be approximately from 20 to 200 nm.

A further metal layer including two metal layer parts 632 and 633 is provided on top of the dielectric layer 640.

Together, at least the transistor channel layer 660, the dielectric layer 640 and the metal layer part 632 define a non-vertical, staggered SD thin-film transistor (TFT) structure, wherein the metal layer part 632 acts as a gate metal for the (semiconductor) transistor channel layer 660.

The stack 600 further includes a transistor channel layer 662 provided on top of the dielectric layer 640. like the transistor channel layer 660, the transistor channel layer 662 is planar with respect to e.g. the substrate 610. The transistor channel layer 662 may for example contain or consist of IGZO. A thickness of the transistor channel layer 662 may for example be approximately between 10 to 50 nm.

A dielectric layer 642 is arranged on top of the transistor channel layer 662. The dielectric layer 642 may for example contain or consist of an oxide, such as e.g. SiO₂. A thickness of the dielectric layer 642 may for example be approximately from 20 to 200 nm.

A metal layer 634 is provided on top of the dielectric layer 642. The metal layer 634 may for example contain or consist of Mo, or other suitable materials.

The formed structure may be exposed to semiconductors 660 and 662 doping, such that the semiconductor regions not covered by layer 632 and 633 and by layer 634 may acquire a reduced resistance to facilitate charge injection to the transistor channel.

Together, at least the transistor channel layer 662, metal layer parts 632 and 633, the dielectric layer 642 and the metal layer 634 with doped regions of semiconductor 662 define a coplanar (top-gate), self-aligned TFT structure, wherein the metal layer 634 acts as a gate metal for the (semiconductor) transistor channel 662. Additionally, the metal layer parts 632 and 633 are arranged such that they contact the transistor channel layer 662, and the metal layer including the metal layer parts 632 and 633 acts as a source-drain metal for the coplanar TFT structure.

The metal layer including the metal layer parts 632 and 633 is thereby configured as both a gate metal for the staggered SD TFT structure and as a source-drain metal for the coplanar TFT structure.

The stack 600 is further covered by a layer 650, which may contain or consist of for example dielectric (such as e.g. SiN or SiO₂, or other suitable alternatives). A thickness of the layer 650 may for example be approximately from 200 to 400 nm. The layer 650 may for example dope parts of the transistor channel layers 660 and 662 not covered by other objects, thereby making these parts conductive.

The stack 600 further includes contacts 670, 672, 674 and 676 provided through the layer 650. The contact 670 contacts the transistor channel layer 660 of the staggered SD TFT structure and may act as a contact to which a light source (such as a LED, an OLED, or similar) may be connected. The contact 670 may for example correspond to the terminal 122 of the circuit 100 illustrated in Figure 1. The contact 672 contacts the (gate) metal layer 634 of the coplanar transistor structure, and may for example correspond to the terminal 116 of the circuit 100 illustrated in Figure 1. The contact 674 contacts the metal layer part 633 of the source-drain metal layer of the coplanar TFT structure, and may for example correspond to the terminal 112 of the circuit 100 illustrated in Figure 1. Finally, the contact 676 contacts the (ground) metal layer 630 of the staggered SD TFT structure, and may for example correspond to the terminal 124 of the circuit 100 illustrated in Figure 1.

In summary, the arrangement of the various contacts and TFT structures of the stack 600 enables the stack 600 to form part of a drive circuit for a pixel, wherein the staggered SD TFT structure is used as a drive transistor and the coplanar TFT structure is used as a select transistor.

In the stack 600, both transistor structures are non-vertical (including a coplanar and a staggered SD TFT structure), which could still lead to reduced area, because there is no need for a VIA to go from the source/drain of the select TFT to the gate of the drive TFT. This elimination of the VIA may reduce the required area of the stack.

In summary, all of the stacks 200, 300, 400, 500, and 600 include a first TFT structure and a second TFT structure. In the stacks 200, 300, 400 and 500, one of the TFT structures is vertical, while the other one of the TFT structures is non-vertical (i.e. coplanar, staggered, or staggered SD). In the stack 600, both TFT structures are non-vertical. Although not illustrated herein, it is further envisaged that stack may instead contain two non-vertical TFT structures which are placed one on top of the other. Such an arrangement may further reduce the required area.

The present disclosure also envisages a display including a plurality of pixels. For each pixel, a driving circuit is provided. The driving circuit may at least partly be formed by a stack as described herein, for example any one of the stacks 200, 300, 400, 500, and 600, as described with reference to Figures 2, 3, 4, 5, and 6, respectively. The display may be of an active-matrix LED type, such as e.g. an active-matrix organic LED (AMOLED) type (i.e. a thin-film emitter type), an active-matrix LED (AMLED) type, an active-matrix polymer LED (AMPLED) type, an active-matrix quantum-dot LED (AMQLED) type, an (AM)PeLED (perovskite LED) type, an (AM)µLED (micro LED) type, or of other suitable and similar types.

In total summary, the present disclosure provides a stack including a first TFT structure and a second TFT structure. As disclosed e.g. by some of the various embodiments provided herein, the first TFT structure may e.g. be a vertical TFT structure, and the second TFT structure may e.g. be a non-vertical TFT structure (such as a coplanar, staggered, or even staggered SD, TFT structure). As also disclosed herein, in other embodiments, both of the first and second TFT structures may be non-vertical.. For all embodiments, using a same metal layer as both a gate metal of one transistor structure and a source-drain metal of the other transistor structure may allow the stack according to the present disclosure to create displays having higher resolutions.

Although features and elements are described above in particular combinations, each feature or element may be used alone without the other features and elements or in various combinations with or without other features and elements

Additionally, variations to the disclosed embodiments can be understood and effected by the skilled person in practicing the claimed invention, from a study of the drawings, the disclosure, and the appended claims. Even if the inventive concept of the present disclosure has mainly been described with reference to a limited number of examples/embodiments, it is readily appreciated by the skilled person that other examples than the ones disclosed above are equally possible within the scope of the inventive concept, as defined by the appended claims.

In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. A semiconductor thin-film transistor, TFT, stack (200, 300, 400, 500, 600), comprising
a first TFT, structure and
a second TFT structure,
wherein a same metal layer (232, 233; 332, 333; 432, 433; 532; 632, 633) is configured as both i) a gate metal of one of the first TFT structure and the second TFT structure, and ii) a source-drain metal of the other one of the first TFT structure and the second TFT structure.

2. The stack of claim 1, wherein the first TFT structure is a vertical TFT structure, and wherein the second TFT structure is a non-vertical TFT structure.

3. The stack of claim 1, wherein both the first TFT structure and the second TFT structure are non-vertical TFT structures.

4. The stack of any one of claims 1 to 3, wherein said same metal layer is configured as a gate metal of the first TFT structure and as a source-drain metal of the second TFT structure.

5. The stack of claim 4, wherein the first TFT structure is configured as a drive transistor and the second TFT structure is configured as a select transistor.

6. The stack of any one of claims 1 to 3, wherein said same metal layer is configured as a source-drain metal of the first TFT structure and as a gate metal of the second TFT structure.

7. The stack of claim 6, wherein the first TFT structure is configured as select transistor and the second TFT structure is configured as a drive transistor.

8. The stack of any one of the preceding claims, wherein the first TFT structure is arranged on top of the second TFT structure.

9. The stack of any one of claims 1 to 7, wherein the second TFT structure is arranged on top of the first TFT structure.

10. The stack of any one of the preceding claims, wherein an active channel layer of one or both of the first TFT structure and the second TFT structure comprises a metal oxide.

11. The stack of claim 10, wherein the metal oxide is indium gallium zinc oxide, IGZO.

12. A display of an active-matrix LED type, comprising a plurality of pixels and, for each pixel, a pixel driving circuit formed at least partly by a semiconductor TFT stack according to any one of the preceding claims.
